# FASCICULE DE BREVET EUROPEEN

(11) **EP 3 712 908 B1**
(45) Date de publication et mention de la délivrance du brevet: **06.10.2021**
(21) Numéro de dépôt: 20163768.3
(22) Date de dépôt: 17.03.2020
(51) Int. Cl.: H01C 7/12, H01T 1/16, H05K 1/18, H01T 4/04

(54) **DISPOSITIF DE PROTECTION CONTRE LES SURTENSIONS**
SCHUTZVORRICHTUNG GEGEN ÜBERSPANNUNGEN
DEVICE FOR SURGE PROTECTION

(30) Priorité: 20.03.2019 FR 1902877
(43) Date de publication de la demande: 23.09.2020
(73) Titulaire: CITEL, 92310 Sèvres (FR)
(72) Inventeur: CREVENAT, Vincent, 51100 Reims (FR)
(74) Mandataire: Loyer & Abello

(56) Documents cités:
- CN-A- 109 075 535
- CN-Y- 201 113 420
- DE-A1-102013 204 039
- FR-E- 38 471
- JP-B2- 3 993 256

## Description

### Domaine technique

L'invention se rapporte au domaine des composants intégrés de protection contre les surtensions pour les équipements électriques.

### Arrière-plan technologique

Pour la protection d'un équipement électrique, il est d'usage d'utiliser, entre les deux lignes d'un secteur alternatif, une varistance à oxyde métallique, notamment à oxyde de zinc, montée en série avec un éclateur à gaz.

Dans un tel dispositif, l'éclateur à gaz supporte pratiquement toute la tension alternative du secteur. En effet, la capacité parasite de l'éclateur est de quelques picofarads alors que la capacité parasite de la varistance est de quelques nanofarads. Lorsque survient une surtension, elle provoque l'amorçage de l'éclateur à gaz, qui ne peut s'éteindre que si le courant, dit de suite, qui le traverse ultérieurement devient suffisamment faible. C'est la résistance de la varistance qui assure la limitation du courant de suite et permet l'extinction de l'éclateur à gaz.

Il existe de nombreux équipements susceptibles d'être protégés par un tel dispositif.

Par exemple, les équipements électroniques, les systèmes téléphoniques et informatiques, les équipements photovoltaïques, les équipements d'éclairage à LEDs et autres.

Cependant, les dispositifs de protection associant des varistances et des éclateurs peuvent être complexes et encombrants. Le document FR38471 divulgue un moyen de contrôler la propagation d'un arc électrique dans un coupe-circuit.

### Résumé

Une idée à la base de l'invention est de fournir un dispositif de protection qui soit simple, peu encombrant et fiable.

Pour cela l'invention décrit, un dispositif de protection contre les surtensions tel que définit à la revendication 1 qui comporte :
- un circuit imprimé,
- une varistance présentant un corps de varistance en oxyde métallique qui présente une face et une couche métallique conductrice déposée sur ladite face,
dans lequel la varistance est reliée à une première borne de connexion électrique par une première piste de connexion du circuit imprimé et une patte de déconnexion, la patte de déconnexion étant directement fixée à la couche métallique par une liaison thermofusible et exerçant sur ladite couche métallique une force de traction de sorte que la patte de déconnexion s'écarte de la couche métallique et coupe la connexion électrique entre la première borne et la varistance en réponse à une fusion de la liaison thermofusible.

Grâce à ces caractéristiques, le dispositif de protection est simple à réaliser. En particulier, la connexion directe entre la patte de déconnexion et la couche métallique ne nécessite pas de liaison terminale en sus de la couche métallique déposée ou de la patte de déconnexion. En particulier, un tel dispositif ne nécessite pas d'électrode en cuivre reliant la couche métallique et la patte de déconnexion.

En outre, grâce à ces caractéristiques, le dispositif est peu encombrant. En particulier, ce dispositif de protection ne nécessite pas d'espace pour une électrode reliant la couche métallique et la patte de déconnexion.

Selon le procédé de fabrication d'un dispositif de protection contre les surtensions de la revendication un tel dispositif de protection contre les surtensions peut comporter une ou plusieurs des caractéristiques suivantes.

Selon un mode de réalisation, la varistance comporte un corps de varistance en oxyde métallique, par exemple en oxyde de zinc.

Selon un mode de réalisation, le dispositif comporte en outre un éclateur à gaz. Selon un mode de réalisation, la varistance et l'éclateur à gaz sont montés en série sur le circuit imprimé.

Selon un mode de réalisation, la ou les couches métalliques sont en argent. Selon un mode de réalisation, la ou les couches métalliques sont des flashs d'argent.

Selon un mode de réalisation, la ou les couches métalliques présentent une épaisseur comprise entre 8 µm et 16 µm, de préférence comprise entre 8 µm et 12 µm, par exemple 10 µm.

Selon un mode de réalisation, la couche métallique est déposée par un procédé par sérigraphie et cuisson.

Selon un mode de réalisation, le corps de la varistance présente une forme cylindrique, de préférence de révolution mais peut également être de section carrée, rectangulaire ou même quelconque. Selon un mode de réalisation, la première face et la deuxième face du corps de la varistance sont parallèles et forment les extrémités de la varistance. Selon un mode de réalisation, la varistance comporte une enveloppe en résine.

Selon un mode de réalisation, la soudure thermofusible est réalisée en un alliage à base d'étain pouvant comporter différents autres métaux tels que le bismuth, l'argent ou le cuivre, la température de fusion étant sélectionnée en variant la composition de l'alliage. Selon un mode de réalisation, l'alliage utilisé pour réaliser la liaison thermofusible ne comporte ni plomb ni cadmium. Selon un mode de réalisation, la brasure thermofusible est constituée d'un alliage d'étain « basse température » dont la température de fusion est comprise entre 130°C et 142°C, de préférence comprise entre 138°C et 142°C. La liaison thermofusible peut être réalisée à l'aide d'un alliage apporté sous la forme d'un fil, d'une patte ou encore d'une préforme, comportant éventuellement un agent nettoyant tel qu'un nettoyant de Flux.

Selon un mode de réalisation, la couche métallique est une première couche métallique conductrice et la face du corps de varistance est une première face dudit corps de varistance et dans lequel la piste du circuit imprimé est une première piste conductrice du circuit imprimé, le corps de varistance comportant en outre une deuxième couche métallique déposée sur une deuxième face du corps de varistance, ladite deuxième face étant opposée à la première face, et dans lequel la varistance est montée sur le circuit imprimé par connexion directe entre ladite deuxième couche métallique conductrice et une deuxième piste du circuit imprimé.

Grâce à ces caractéristiques, le dispositif est simple de fabrication. En particulier, la connexion directe entre la deuxième couche métallique déposée et la deuxième piste conductrice ne nécessite pas de composant supplémentaire pour assurer la connexion entre la varistance et la deuxième piste conductrice. En outre, une telle connexion directe entre la varistance et la deuxième piste conductrice présente un faible encombrement, le dispositif présentant en conséquence également un faible encombrement.

Selon un mode de réalisation, la patte de déconnexion est une lame ressort précontrainte par la liaison thermofusible entre une extrémité de ladite lame ressort et la couche métallique conductrice.

Grâce à ces caractéristiques, la liaison thermofusible entre la patte de déconnexion et la varistance est simple tout en garantissant la déconnexion entre la patte de déconnexion et la varistance lors de la fusion de la liaison thermofusible. En effet, à l'état opérationnel la connexion entre la patte de déconnexion et la varistance est assurée par la liaison thermofusible et, lorsque ladite liaison thermofusible est dégradée, la lame ressort permet l'éloignement entre la patte de déconnexion et la varistance sans nécessiter d'élément supplémentaire pour écarter ladite patte de déconnexion de la varistance, la lame ressort n'étant plus précontrainte par la liaison thermofusible s'écarte sans aide extérieure de la varistance.

Selon un mode de réalisation, la force de précontrainte appliquée sur la patte de déconnexion et maintenue par la liaison thermofusible est comprise entre 5 N (Newton) et 10 N, de préférence comprise entre 6 N et 7 N, idéalement de 6,5 N. Une telle force de précontrainte est insuffisante pour dégrader la couche métallique qui est relativement fine tout en permettant l'écartement entre la patte de déconnexion et la couche métallique en l'absence de force opposée, typiquement lorsque la liaison thermofusible fusionne.

Selon un mode de réalisation, la patte de déconnexion est composée d'un alliage de cuivre.

Selon un mode de réalisation, la patte de déconnexion est composée d'un alliage de cuivre, de béryllium et de Nickel. Un tel alliage permet d'obtenir une conductivité optimale pour la patte de déconnexion ainsi qu'une élasticité satisfaisante pour ne pas dégrader la couche métallique sous l'effet de la précontrainte exercée par la patte de déconnexion sur ladite couche métallique.

Selon un mode de réalisation, la patte de déconnexion présente une portion d'ancrage fixée sur la première piste, une portion flexible se développant entre la portion d'ancrage et la face du corps de varistance, et une portion de fixation fixée sur la couche métallique par la liaison thermofusible.

Selon un mode de réalisation, la patte de déconnexion présente une élasticité caractérisée par un déplacement de la portion de fixation selon une direction perpendiculaire à la face de la varistance de 4 mm pour une force comprise entre 5 N et 10 N, de préférence comprise entre 6 N et 7 N et idéalement de 6,5 N. appliquée sur ladite portion de fixation selon ladite direction de déplacement.

Selon un mode de réalisation, la portion d'ancrage présente une longueur comprise entre 4 mm et 6 mm, de préférence 4,45 mm. Selon un mode de réalisation, la portion flexible présente une longueur comprise entre 16 mm et 18 mm, de préférence de 17,2 mm.

Selon un mode de réalisation, la portion de fixation présente une longueur comprise entre 1,5 mm et 4 mm, de préférence de 2,68 mm. Lesdites longueurs sont prises selon une direction longitudinale de la patte de déconnexion. Selon un mode de réalisation, la patte de déconnexion présente en outre une épaisseur comprise entre 0.3 et 0,6 mm, de préférence de 0,4 mm.

Selon un mode de réalisation, la patte de déconnexion présente une largeur comprise entre 3 et 7 mm, de préférence de 4 mm.

Selon un mode de réalisation, la patte de déconnexion présente une raideur comprise entre 1250 N/m, de préférence comprise entre 1500 N/m et 1750 N/m, idéalement de 1625 N/ m.

Selon un mode de réalisation, la patte de déconnexion présente une dureté Vickers comprise entre 250 et 310.

Selon un mode de réalisation, la patte de déconnexion présente une conductivité électrique IACS supérieure ou égale à 48%.

La surface de contact entre la lame de déconnexion et la première couche métallique est déterminée en fonction du courant de foudre visé pour le dispositif de protection contre les surtensions. Selon un mode de réalisation, une surface de contact entre la patte de déconnexion et la première couche métallique est comprise entre 15,5 mm² et 17,5 mm², de préférence de 16,5 mm².

Selon un mode de réalisation, la lame de déconnexion est brute. Selon un mode de réalisation, la lame de déconnexion présente un traitement de surface, par exemple un traitement d'Argenture, d'étamage ou autre.

Selon un mode de réalisation, le dispositif de protection présente une résistance électrique supérieure ou égale à 0,6 mΩ.

Selon un mode de réalisation, le dispositif de protection contre les surtensions comporte en outre un boîtier de protection agencé autour de la varistance. Selon un mode de réalisation, le boîtier est agencé autour de l'éclateur à gaz.

Un tel boîtier de protection permet de protéger les composant du dispositif de protection, en particulier lors de la manipulation dudit dispositif en vue de son installation dans un circuit électrique.

Selon un mode de réalisation, le boîtier de protection comporte un réceptacle formant un logement interne, la varistance étant logée dans ledit logement interne, ledit réceptacle présentant une ouverture. Selon un mode de réalisation, l'éclateur à gaz est logé dans ledit logement.

Selon un mode de réalisation, le circuit imprimé forme un couvercle du réceptacle de sorte que ledit circuit imprimé forme un fond du boîtier de protection.

Selon un mode de réalisation, la première couche métallique est reliée à une troisième piste de connexion du circuit imprimée par une patte de connexion. Selon un mode de réalisation, cette troisième piste de connexion relie la patte de connexion et une troisième borne de connexion électrique.

Selon un mode de réalisation, le circuit imprimé comporte une quatrième piste conductrice reliant l'éclateur à gaz et la deuxième borne de connexion électrique.

Selon un mode de réalisation, le circuit imprimé comporte une cinquième piste conductrice reliant la deuxième couche métallique de la varistance et une quatrième borne de connexion électrique.

Selon un mode de réalisation, le circuit imprimé comporte une sixième piste conductrice reliant la deuxième piste conductrice et une cinquième borne de connexion électrique.

Selon un mode de réalisation, l'invention fournit également selon un mode de réalisation utile à la compréhension de l'invention, un procédé de fabrication d'un dispositif de protection contre les surtensions comportant :
- fournir un circuit imprimé comportant une pluralité de bornes de connexion électrique et une pluralité de pistes conductrices,
- fournir une varistance présentant un corps de varistance en oxyde métallique qui présente une face et une couche métallique conductrice déposée sur ladite face,
- fixer une patte de déconnexion sur une première piste du circuit imprimé, ladite première piste reliant ladite patte de déconnexion et une première borne de connexion électrique, une patte à braser étant agencée entre la patte de déconnexion et la première piste,
- fixer la varistance sur le circuit imprimé de sorte qu'une extrémité de la patte de déconnexion opposée à la première piste soit en vis-à-vis et à distance de la première couche métallique de la varistance, une patte à braser étant agencée entre la varistance et le circuit imprimé,
- déformer élastiquement la patte de déconnexion de manière à amener la deuxième extrémité de ladite patte de déconnexion en contact avec la couche métallique, et
- réaliser une soudure thermofusible entre ladite extrémité de la patte de déconnexion et la couche métallique.

Le procédé peut également comporté postérieurement à la réalisation de la soudure thermofusible, le dépôt d'un vernis sur le dispositif de protection.

Le procédé peut également comporté l'étape suivante: :
- chauffer dans un four le dispositif de manière à réaliser une brasure entre le circuit imprimé et d'une part la varistance et, d'autre part, la patte de déconnexion.

Par ailleurs, le vernis peut être déposé par diffusion, par exemple au moyen d'un spray de vernis ou de résine.

Selon le procédé, la chauffe dans le four se fait à une température supérieure ou égale à 200°C, par exemple de 270°C.

Selon un mode de réalisation, la soudure thermofusible est réalisée par une brasure thermofusible.

Selon un mode de réalisation, la cuisson de la ou des couches métalliques déposées sur le corps de varistance comporte une phase de séchage et une phase de fixation. Selon un mode de réalisation, la phase de séchage est réalisée à une température comprise entre 130°C et 170°C, par exemple de 150°C. Selon un mode de réalisation, la phase de séchage est réalisée durant une durée comprise entre 3 minutes et 20 minutes, par exemple comprise entre 3 minutes et 5 minutes à 150°C. Selon un mode de réalisation, la phase de fixation est réalisée à une température comprise entre 500°C et 700°C, de préférence 600°C. Selon un mode de réalisation, la phase de fixation est réalisée durant une durée comprise entre 5 heures et 24 heures.

Selon un premier aspect, , l'invention fournit un dispositif de protection contre les surtensions tel que définit par la revendication 1 comportant :
- un circuit imprimé,
- une varistance,
- un éclateur à gaz, la varistance et l'éclateur à gaz étant connectés en série entre une première borne de connexion électrique et une deuxième borne de connexion électrique du circuit imprimé,
dans lequel :
- la varistance est reliée à la première borne par une première piste conductrice du circuit imprimé,
- l'éclateur à gaz est relié à la varistance par une deuxième piste conductrice du circuit imprimé,
- l'éclateur à gaz est relié à la deuxième borne de connexion électrique par une troisième piste de connexion du circuit imprimé,
et dans lequel la deuxième piste et la troisième pistes comportent chacune une portion courbe, lesdites portions courbes étant connectées à l'éclateur à gaz et situées de part et d'autre de l'éclateur à gaz, lesdites portions courbes présentant chacune une concavité tournée selon une même orientation par rapport à l'éclateur à gaz, lesdites portions courbes comportant chacune une zone thermofusible apte à séparer la piste correspondante en deux parties distinctes en réponse à une surintensité, la distance séparant lesdites deux parties distinctes de chaque piste étant configurée pour permettre la génération d'un arc électrique entre lesdites deux parties distinctes en réponse d'une part à une surtension apte à activer l'éclateur à gaz et, d'autre part, un courant et une tension maintenant ledit éclateur à gaz en état de conduction.

Grâce à ces caractéristiques, les deuxième et troisième pistes constituent des zones fusibles à même de protéger l'éclateur à gaz, l'arc électrique généré en cas de surtension étant divisé en trois arcs en série, un arc électrique étant généré dans l'éclateur à gaz et au niveau de chacune des zones thermofusibles, permettant ainsi une meilleure maîtrise desdits arcs. En outre, les portions amincies étant agencées sur des portions courbes permettent d'orienter les arcs électriques générés au niveau desdites portions amincies de sorte que les arcs électriques générés au niveau desdites portions amincies soient orientés selon des direction opposées, limitant les risques de perturbation entre lesdits arcs électriques et facilitant l'extinction desdits arcs, comparativement à un unique arc.

Selon des modes de réalisation, un tel dispositif de protection contre les surtensions peut comporter une ou plusieurs des caractéristiques suivantes, en plus des caractéristiques déjà indiquées ci-dessus.

Selon un mode de réalisation, la première piste conductrice, la deuxième piste conductrice et la troisième piste conductrice forment conjointement une boucle de champ magnétique ouverte entre la première borne électrique et la deuxième borne électrique en présence de courant entre lesdites première borne électrique et deuxième borne électrique. Une telle boucle de champs magnétique permet une orientation des arcs générés au niveau des zones thermofusibles de sorte que lesdits arcs ne se perturbent pas.

Selon un mode de réalisation, un rayon d'un cercle tangent à la zone thermofusible de la deuxième piste conductrice forme un angle compris entre 80 et 100° (degrés), et de préférence un angle de 90°, avec un rayon d'un cercle tangent à la zone thermofusible de la troisième piste conductrice. Grâce à ces caractéristiques, les risques de perturbations entre les arcs générés au niveau des zones thermofusibles sont réduits et l'extinction des arcs est facilitée.

Selon un mode de réalisation, la varistance est reliée à une troisième borne électrique par une patte de déconnexion, ladite patte de déconnexion étant reliée à la varistance par une liaison thermofusible apte couper la liaison entre la troisième borne électrique et la varistance en réponse à une élévation de la température de la varistance au-delà d'une valeur seuil, ladite première borne électrique étant destinée à être connectée à la phase d'un circuit d'alimentation électrique.

Selon un mode de réalisation, la première borne électrique est destinée à être connectée au neutre d'un circuit d'alimentation électrique et la deuxième borne électrique est destiné à être relié à la terre, l'éclateur à gaz étant relié à une quatrième borne électrique par une quatrième piste conductrice, ladite quatrième piste conductrice étant connectée à la deuxième piste conductrice, ladite quatrième borne électrique étant destinée à être connectée au neutre d'un circuit électrique alimenté par le circuit d'alimentation électrique.

Selon un mode de réalisation, la varistance est reliée à une cinquième borne électrique par une sixième piste conductrice, ladite cinquième borne électrique étant destinée à être connectée à la phase du circuit électrique alimenté par le circuit d'alimentation électrique.

Selon un deuxième aspect, l'invention fournit également un procédé de fabrication d'un dispositif contre les surtensions précité tel que définit par la revendication 7 comportant
- fournir un circuit imprimé comportant une pluralité de bornes de connexion électrique et une pluralité de pistes de connexion conductrices,
- fournir une varistance,
- fournir un éclateur à gaz,
- déposer la varistance sur le circuit imprimé de sorte que la varistance soit reliée à une première borne de connexion électrique par une première piste conductrice,
- déposer l'éclateur à gaz sur le circuit imprimé de sorte que la varistance et l'éclateur à gaz soient connectés en série entre la première borne de connexion électrique et une deuxième borne de connexion électrique du circuit imprimé via une deuxième piste conductrice reliant la varistance et l'éclateur à gaz et une troisième piste conductrice reliant l'éclateur à gaz à ladite deuxième borne de connexion électrique, la deuxième piste et la troisième piste comportant chacune une portion courbe, lesdites portions courbes étant connectées à l'éclateur à gaz et situées de part et d'autre de l'éclateur à gaz, lesdites portions courbes présentant chacune une concavité tournée selon une même orientation par rapport à l'éclateur à gaz, lesdites portions courbes comportant chacune une zone thermofusible apte à séparer la piste correspondante en deux parties distinctes en réponse à une surintensité, la distance séparant lesdites deux parties distinctes desdites pistes étant configurée pour permettre la génération d'un arc électrique entre lesdites deux parties distinctes en réponse à d'une part une surtension apte à activer l'éclateur à gaz et, d'autre part, un courant et une tension maintenant ledit éclateur à gaz en état de conduction.

Selon un mode de réalisation, dans un tel procédé de fabrication la varistance présente un corps de varistance en oxyde métallique qui présente une face et une couche métallique conductrice déposée sur ladite face.

Selon un mode de réalisation, un tel procédé de fabrication peut en outre comporter, en plus des caractéristiques indiquées ci-dessus,:
- déposer une patte de déconnexion sur une quatrième piste du circuit imprimé, ladite quatrième piste reliant ladite patte de déconnexion et une troisième borne de connexion électrique, l'étape de déposer la varistance sur le circuit imprimé est réalisée de sorte extrémité de la patte de déconnexion opposée à la première piste soit en vis-à-vis et à distance de la couche métallique de la varistance,
- déformer élastiquement la patte de déconnexion de manière à amener la deuxième extrémité de ladite patte de déconnexion en contact avec la couche métallique, et
- réaliser une soudure thermofusible entre ladite extrémité de la patte de déconnexion et la couche métallique.

### Brève description des figures

. L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.
[fig.1] la figure 1 est une vue en perspective schématique d'un dispositif de protection contre les surtensions ;
[fig.2] la figure 2 est une vue en perspective schématique du circuit imprimé et des composants montés sur ledit circuit imprimé du dispositif de protection contre la surtension de la figure 1 ;
[fig.3] la figure 3 est une vue en coupe de la figure 2 au niveau de la varistance ;
[fig.4] la figure 4 est une vue en coupe de la patte de déconnexion de la figure 3 ;
[fig.5] la figure 5 est une vue de dessus du circuit imprimé de la figure 2 dans laquelle les composants montés sur ledit circuit imprimé sont omis et illustrant les forces magnétiques générées par un courant passant par l'éclateur à gaz ;
[fig.6] la figure 6 est une vue de dessus du circuit imprimé de la figure 2 dans laquelle les composants montés sur ledit circuit imprimé sont omis et illustrant les zones de génération d'arcs en présence d'une surtension ;
[fig.7] la figure 7 est une vue de dessus du circuit imprimé de la figure 2 dans laquelle les composants montés sur ledit circuit imprimé sont omis et illustrant l'orientation des arcs générés en présence d'une surtension.

### Description des modes de réalisation

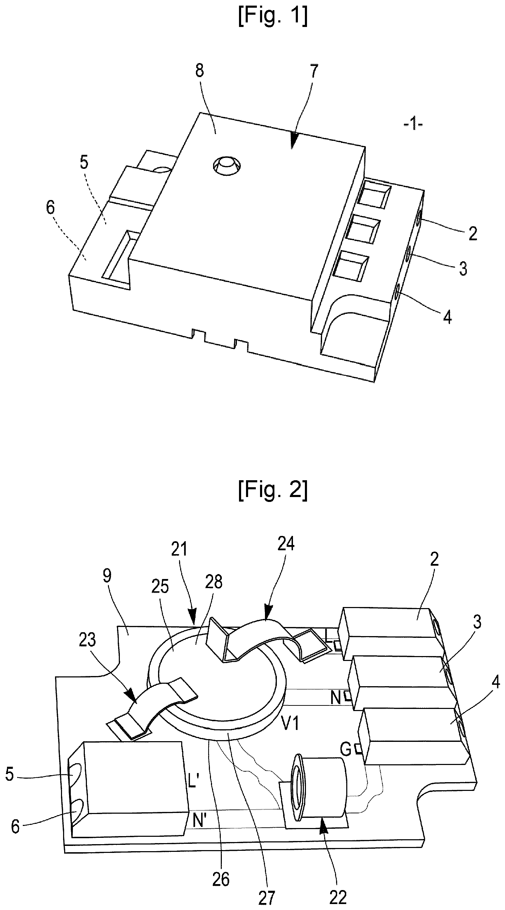

Un dispositif de protection contre les surtensions, ci-après dispositif 1, tel qu'illustré sur les figures 1 à 7 est destiné à être intégré à un circuit électrique afin de protéger un ou des appareils électriques dudit circuit électrique contre les surtensions. De tels appareils électriques sont par exemple des dispositifs d'éclairage à LED ou autre. Ainsi, le dispositif 1 comporte des bornes conductrices destinées à recevoir des câbles du circuit électrique. Sur la figure 1, le dispositif 1 comporte une première borne conductrice 2 destinée à être reliée à la phase, une deuxième borne conductrice 3 destinée à être reliée au neutre et une troisième borne conductrice 4 destinée à être reliée à la terre. Ce dispositif 1 comporte en outre une quatrième borne conductrice 5 et une cinquième borne conductrice 6 destinées à relier le dispositif 1 au circuit électrique (non représenté).

Ce dispositif 1 comporte un boîtier 7 dans lequel sont logés les différents composant dudit dispositif 1. Les bornes conductrices 2 à 6 débordent du boîtier 7 afin de permettre leur liaison avec le circuit d'alimentation ou le circuit électrique à alimenter. Ce boîtier 7 comporte un réceptacle 8 formant un logement interne dans lequel sont logés les différents composants du dispositif 1.

Comme illustré sur la figure 2, le dispositif 1 comporte un circuit imprimé 9. De façon avantageuse, ce circuit imprimé 9 forme un couvercle du boîtier 7 et coopère avec le réceptacle 8 pour ferme le boîter 7 en logeant dans le logement interne les différents composants du dispositif 1.

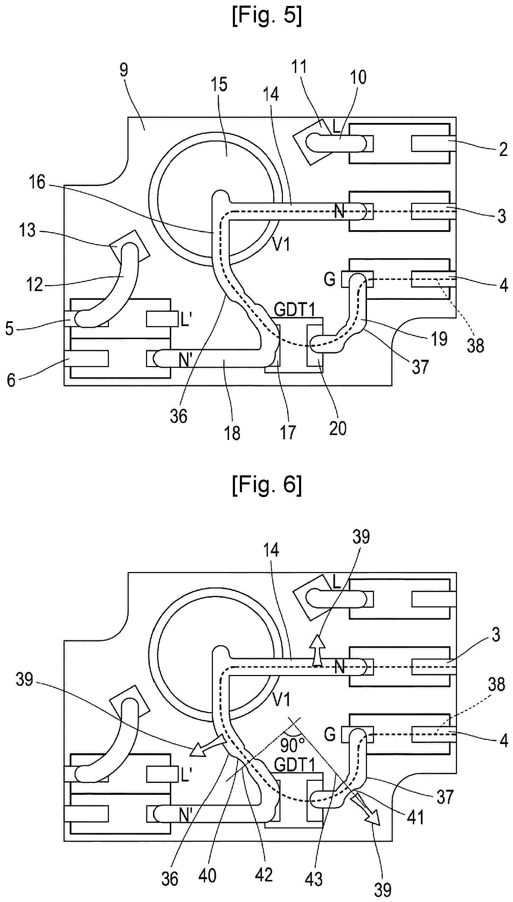

Le circuit imprimé 9 comporte une pluralité de pistes conductrices permettant de connecter électriquement les différents composants du dispositif 1 entre eux et aux bornes conductrices 2 à 6. Plus particulièrement, par exemple comme illustré sur la figure 5, le circuit imprimé 9 comporte une première piste conductrice 10 reliant électriquement la première borne électrique 2 à une première zone de connexion 11. Une deuxième piste conductrice 12 du circuit imprimé 9 relie une deuxième zone de connexion 13 à la quatrième borne électrique 5. Une troisième piste conductrice 14 relie une troisième zone de connexion 15 à la troisième borne électrique 3. Cette troisième zone de connexion 15 est également reliée via une quatrième piste conductrice 16 à une quatrième zone de connexion 17. Une cinquième piste conductrice 18 relie ladite quatrième zone de connexion 17 à la cinquième borne conductrice 6. Enfin, une sixième piste conductrice 19 relie une cinquième zone de connexion 20 à la troisième borne électrique 4.

Comme illustré sur la figure 2, le dispositif 1 comporte en outre une varistance 21, un éclateur à gaz 22, une patte de connexion 23 et une patte de déconnexion 24.

La varistance 21 comporte un corps en oxyde métallique, par exemple un corps de varistance en oxyde de zinc. Le corps de la varistance présente une première face 25 et une deuxième face 26 planes et parallèles. Le corps de la varistance 21 est de forme cylindrique de révolution, la première face 25 et la deuxième face 26 étant de formes circulaires. Une face latérale 27 du corps de la varistance 21 est de préférence recouverte par une résine époxy.

La première face 25 est recouverte par une première couche métallique 28 en matériau conducteur. Cette première couche métallique 28 est par exemple un flash d'argent déposé sur la première face 25 au moyen d'un procédé de dépose par sérigraphie. Une telle première couche métallique 28 est par exemple séchée par passage dans un four. Un tel passage dans le four se fait par exemple à une température comprise entre 130°C et 170°C pendant quelques minutes. Par exemple, le passage au four présente une exposition de la première couche métallique 28 à une température de 150°C pendant au moins 3 à 5 minutes. La première couche métallique est ensuite fixée lors d'une cuisson à une température comprise entre 500°C et 700°C, par exemple 600°C, pendant une durée comprise entre 5 heures et 24 heures. Une telle première couche métallique déposée 28 présente une épaisseur faible par comparaison avec l'épaisseur de la varistance 21, par exemple de l'ordre de 8 µm à 16 µm, de préférence comprise entre 8 µm et 12 µm, idéalement de 10 µm.

De façon analogue, la deuxième face 26 du corps de la varistance 21 est également recouverte par une deuxième couche métallique déposée, par exemple en Argent. Cette deuxième couche métallique est réalisée de façon analogue à la première couche métallique 28, par un procédé de dépose par sérigraphie suivi d'une étape de séchage et d'une étape de fixation.

La varistance 21 est directement montée sur le circuit imprimé 9. Plus particulièrement, la deuxième couche métallique déposée sur la deuxième face 26 du corps de la varistance 21 est directement montée sur le circuit imprimé 9 au niveau de la troisième zone de connexion 15. En d'autres termes, la deuxième couche métallique déposée sur la deuxième face 26 du corps de la varistance est directement connectée au niveau de ladite troisième zone de connexion 15 à la troisième piste conductrice 14 et à la quatrième piste conductrice 16. Ainsi, ladite troisième piste conductrice 15 relie directement la varistance 21 à la deuxième borne électrique 3.

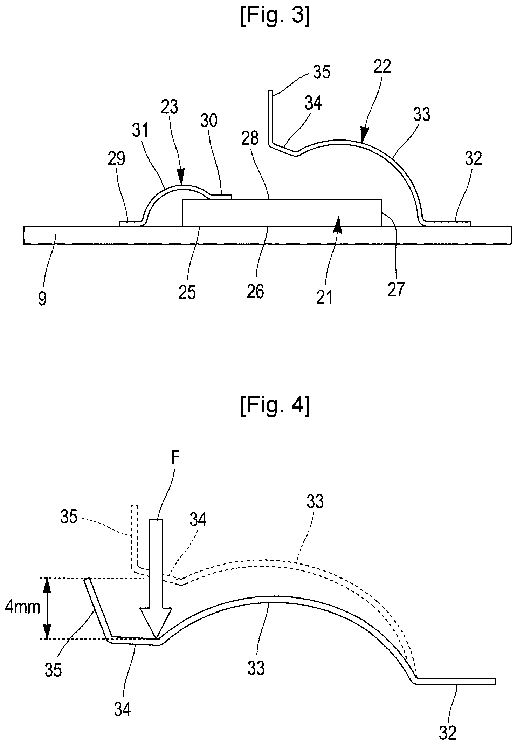

Par ailleurs, la varistance 21 est également connectée à la première zone de connexion 11 et à la deuxième zone de connexion 13. Plus particulièrement, la patte de déconnexion 24 comporte une première extrémité montée dans la première zone de connexion 11, et donc électriquement connectée à la première piste conductrice 10, et une deuxième extrémité montée sur la première couche métallique 28 comme cela est expliqué plus en détails ci-dessous en regard des figures 3 et 4. En outre, la patte de connexion 23 présente une première extrémité 29 montée dans la deuxième zone de connexion 13, et donc connectée à la deuxième piste conductrice 12, et une deuxième extrémité 30 montée sur la première couche métallique 28.

L'éclateur à gaz 22 est lui monté sur le circuit imprimé 9 au niveau de la quatrième zone de connexion 17 et de la cinquième zone de connexion 20. Typiquement, une première borne dudit éclateur à gaz 22 est reliée à la quatrième zone de connexion 17, c'est-à-dire à la quatrième piste conductrice 16 et à la cinquième piste conductrice 18, et une deuxième borne dudit éclateur à gaz 22 est reliée à la cinquième zone de connexion 20, et donc à la sixième piste conductrice 19. Ainsi, la première borne de l'éclateur à gaz 22 est électriquement reliée d'une part à la varistance 21 via la quatrième piste conductrice 16 et, d'autre part, à la cinquième borne électrique 6 via la cinquième piste conductrice 18. En outre, la deuxième borne de l'éclateur à gaz 22 est reliée à la troisième borne électrique 4 via la sixième piste conductrice 19.

Ainsi, le circuit imprimé 9 sert à la fois de support pour la varistance 21, l'éclateur à gaz 22 et les pattes de connexion 23 et de déconnexion 24, de connexion entre les composants grâce aux pistes conductrices 10, 12, 14, 16, 18, 19, et de fond du boîtier 7.

La liaison entre le circuit imprimé 9 et la varistance 21 est décrite ci-après en regard des figures 3 et 4.

La première extrémité 29 de la patte de connexion 23 est plane de manière à pouvoir être fixée sur le circuit imprimé 9 au niveau de la deuxième zone de connexion 13, c'est-à-dire en contact avec la deuxième piste conductrice 12. De même, la deuxième extrémité 30 de ladite patte de connexion 23 est plane de manière à pouvoir est fixée sur la première couche métallique 28. La patte de connexion comporte une portion centrale 31 courbe reliant la première extrémité 29 et la deuxième extrémité 30. Cette portion centrale 31 est rigide et agencée de manière à ne pas exercer de contrainte sur le circuit imprimé 9 et/ou sur la première couche métallique 28.

La patte de déconnexion 24 présente la forme d'une lame ressort. Cette patte de déconnexion 24 est par exemple réalisée en alliage de cuivre. La patte de déconnexion 24 est par exemple réalisée dans un alliage de cuivre, de Béryllium et de Nickel, un tel alliage permettant d'obtenir une bonne conductivité ainsi qu'une bonne élasticité.

La patte de déconnexion 24 comporte, successivement selon une direction longitudinale de ladite patte de déconnexion 24, une portion d'ancrage 32, une portion flexible 33, une portion de fixation 34 et un retour 35. De façon analogue aux extrémités 29 et 30 de la patte de connexion 23, la portion d'ancrage 32 de la patte de déconnexion 24 est plane de manière à pouvoir être fixée sur le circuit imprimé 9 au niveau de la première zone de connexion 11 électriquement connectée à la première piste conductrice 10.

La portion de fixation 34 est directement fixée sur la première couche métallique 28, c'est-à-dire que la première couche métallique 28 remplit la fonction d'électrode de connexion de la varistance 21. La portion de fixation 34 est plane de manière à assurer une fixation stable sur de ladite portion de fixation 34 sur la première couche métallique 28. La surface de contact entre la portion de fixation et la première couche métallique est déterminée en fonction du courant de foudre visé pour le dispositif 1. La portion de fixation 34 présente par exemple une surface de contact comprise entre 5 mm² et 17,5 mm², par exemple de 9 mm² ou de 16,5 mm², avec la première couche métallique 28. Cette liaison entre la portion de fixation 34 et la première couche métallique 28 est réalisée au moyen d'une liaison thermofusible, c'est-à-dire une liaison apte à se dégrader en réponse à une température dépassant une valeur seuil par exemple une température seuil comprise entre 130°C et 142°C, de préférence entre 138°C et 142°C. Cette liaison thermofusible est réalisée par tout moyen adapté, par exemple par une soudure basse température. Cette soudure thermofusible peut être réalisée avec apport de matière comme par exemple de l'étain ou autre. Cet apport de matière est par exemple un alliage d'étain sans plomb ni cadmium sous forme de fil, de patte ou de préforme associé avec un agent nettoyant tel que du flux de soudure.

La portion flexible 33 qui relie la portion d'ancrage 32 et la portion de fixation 34 est courbe et élastique. Cette portion flexible 33 permet d'écarter la portion de fixation 34 da la première couche métallique 28 lorsque la liaison thermofusible se dégrade. Pour assurer cet écartement entre la portion de fixation 34 et la première couche métallique 28 lorsque la liaison thermofusible se dégrade, la patte de déconnexion 24 est précontrainte. Cependant, la première couche métallique 28 étant relativement fine, de l'ordre de quelques µm, par exemple comprise entre 8µm et 16µm, de préférence entre 8 µm et 12 µm par exemple 10 µm, la portion flexible 33 doit présenter des caractéristiques élastiques telles que cette précontrainte ne soit pas trop importante. En effet, une précontrainte trop importante pourrait arracher la première couche métallique 28 déposée sur le corps de la varistance 21 et dégrader en conséquence la varistance 21. Cependant, la portion flexible 33 doit présenter une élasticité suffisante pour écarter de façon satisfaisante la portion de fixation 34 de la première couche métallique 28 lorsque la liaison thermofusible se dégrade.

Dans un exemple de réalisation, la portion flexible 33 présente par exemple une longueur comprise entre 16 mm et 18 mm, de préférence de 17,2 mm, une largeur comprise entre 3 et 7 mm, de préférence de 4 mm et une épaisseur comprise entre 0,3 et 0,6 mm, de préférence de 0,4 mm. Dans cet exemple, comme illustré sur la figure 4, la portion flexible 33 présente une élasticité telle qu'une force F comprise entre 5 N et 10 N, de préférence 6,5 N, appliquée au niveau de la jonction entre la portion flexible 33 et la portion de fixation 34 et selon une direction perpendiculaire au plan de la portion d'ancrage 32 implique un déplacement de 4 mm au niveau de ladite jonction.

Pour que les caractéristiques d'élasticité de la portion flexible soient atteintes, la patte de déconnexion 24 peut être soumise à différents traitement, comme par exemple un traitement thermique par trempe destiné à lui donner ces caractéristiques mécaniques souhaitée. La lame de déconnexion 24 peut par exemple être brute ou traitée en surface, par exemple par Argenture ou étamage. La lame de déconnexion 24 présente une raideur comprise entre 1250 N/m et 2500 N/m, de préférence comprise entre 1500 N/m et 1750 N/m et idéalement de 1650 N/m. La lame de déconnexion présente de préférence une dureté Vickers comprise entre 250 et 310.

En regard de la figure 5, l'on observe que la quatrième piste conductrice 16 comporte une première portion courbe 36. De même la sixième piste conductrice 19 comporte une deuxième portion courbe 37. La première portion courbe 36 et la deuxième portion courbe 37 présentent un centre de courbure situé d'un même coté desdites pistes conductrices 16 et 19. Autrement dit, la première portion courbe et la deuxième portion courbe présentent des concavités respectives tournées l'une vers l'autre. Ainsi, comme illustré sur la figure 5 la liaison entre la deuxième borne électrique 3 et la troisième borne électrique 4 présente sensiblement la forme d'une boucle ouverte 38 entre lesdites bornes électriques 3 et 4, cette boucle ouverte 38 étant schématiquement illustrée sur les figures 5 et 6 en traits pointillés. Cet boucle ouverte 38 transite par la troisième piste conductrice 14, la quatrième piste conductrice 16 et la sixième piste conductrice 19 via l'éclateur à gaz 22 (non illustré sur les figures 5 et 6). Ainsi, en présence de courant électrique transitant par cette boucle ouverte 38, des forces magnétiques sont générées vers l'extérieur de cette boucle, comme illustré par les flèches 39 sur la figure 6.

La première portion courbe 36 comporte une première portion de piste amincie 40. De même, la deuxième portion courbe 37 présente une deuxième portion de piste amincie 41. Ces portions amincies 40 et 41 forment des zones fusibles se dégradant en présence d'une surintensité. Plus particulièrement, comme expliqué ci-après, une surintensité transitant par ces portions de pistes amincies 40 et 41 provoque leur fusion ce qui interrompt la piste conductrice correspondante au niveau de ladite portion de piste amincie, remplissant la fonction de zone fusible.

De préférence, une tangente à la première portion courbe 36 au niveau de la première portion amincie 40, prise de préférence au milieu de ladite première portion amincie 40, est perpendiculaire à une tangente à la deuxième portion courbe 37 au niveau de la deuxième portion amincie 41, prise de préférence au milieu de ladite deuxième portion amincie 41. Autrement dit, un cercle tangent au milieu de la première portion amincie 40 présente un rayon formant un angle compris entre 80° et 100°, de préférence 90° comme illustré sur les figures, avec le rayon d'un cercle tangent au milieu à la deuxième portion amincie 41. De tels rayons perpendiculaires sont illustrés par exemple sur la figure 6 avec les références 42 pour la première portion courbe 36 et 43 pour la deuxième portion courbe 37.

En fonctionnement normal du circuit électrique, le courant circule entre la première borne électrique 2 et la quatrième borne électrique 5 via la première piste conductrice 10, la patte de déconnexion 24, la première couche métallique 28, la patte de connexion 23 et la deuxième piste conductrice 12. Par ailleurs, en fonctionnement normal du circuit électrique, le courant circule également entre la cinquième borne électrique 6 et la deuxième borne électrique 3 via la cinquième piste conductrice 18, la quatrième piste conductrice 16 et la troisième piste électrique 14.

La varistance 21 et l'éclateur à gaz 22 permettent la protection du circuit électrique en présence d'une surtension.

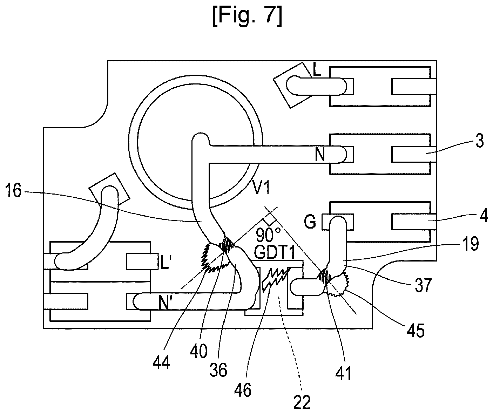

En présence d'une surtension, un arc électrique 46 illustré sur la figure 7 est généré dans l'éclateur à gaz 22 reliant ainsi le circuit électrique et la troisième borne électrique 3, typiquement la borne électrique destinée à être reliée à la terre.

La première portion amincie 40 fusionne sous l'effet de la surintensité, la quatrième piste conductrice 16 étant ainsi interrompue au niveau de ladite première portion amincie 40 ayant fusionnée. De même, la deuxième portion amincie 41 fusionne sous l'effet de la surintensité, la sixième piste conductrice 19 étant ainsi interrompue au niveau de ladite deuxième portion amincie 41 ayant fusionnée. La longueur de la première portion amincie 40 est calibrée de sorte que, après fusion de ladite première portion amincie 40, un arc électrique 44 est généré et maintenu par la présence de courant et d'une intensité entre les parties de la quatrième piste conductrice 16 séparées par ladite première portion amincie 40 ayant fusionné. De façon analogue, la longueur de la deuxième portion amincie 41 est telle qu'une surintensité génère la fusion de la deuxième portion amincie et qu'un arc électrique 45 entre les parties de la sixième piste conductrice 19 séparées lors de la fusion de la deuxième portion amincie 41 puisse être maintenu par la présence d'un courant et d'une intensité.

Autrement dit, en présence d'une surintensité, la première portion amincie 40 et la deuxième portion amincie 41 permettent de morceler l'arc électrique normalement généré dans l'éclateur à gaz 22 en trois arcs électriques en série, un premier arc 44 étant localisé sur la quatrième piste conductrice 16, un deuxième arc 46 dans l'éclateur à gaz 22 et un troisième arc 45 sur la sixième piste conductrice 19. Ce morcèlement en plusieurs arcs électriques 44, 45 et 46 offre une meilleure capacité à interrompre ces arcs.

Par ailleurs le fait que les portions amincies 40 et 41 soient localisées sur des portions courbes dont les rayons de courbure sont situés d'un même coté permet avantageusement d'orienter les arcs 44 et 45. Comme expliqué ci-dessus, la courbure des pistes 36 et 37 permet de former la boucle ouverte 38. Les arcs 44 et 45 générés sur les portions courbes 36 et 37 d'une telle boucle ouverte 38, typiquement au niveau des portions amincies 40 et 41, sont générés vers l'extérieur de cette boucle ouverte 38. En conséquence, comme illustré sur la figure 7, les arcs 44 et 45 générés au niveau des portions amincies 40 et 41 sont donc orientés vers l'extérieur de la boucle ouverte 38 et donc dans des directions opposées, évitant ainsi que ces arcs 44 et 45 ne se perturbent et s'entretiennent pas mutuellement. Cette orientation des arcs 44 et 45 du fait des portions courbes 36 et 37 assure ainsi que les portions amincies 40 et 41 protègent de façon efficace l'éclateur à gaz 22 en divisant l'arc maintenu par le courant et l'intensité en trois arcs 44, 45 et 46, deux desdits arcs distincts étant situés de part et d'autre dudit éclateur à gaz 22.

Par ailleurs, en présence d'une surintensité, la liaison thermofusible entre la patte de déconnexion 24 et la première couche métallique 28 de la varistance 21 fusionne. Dès lors, la première couche métallique 28 n'exerce plus sur la portion de fixation 34 via la liaison thermofusible une force de retenue s'opposant à la force exercée sur ladite portion de fixation 34 par la portion flexible 33. La portion flexible 33, en l'absence de force opposée, écarte élastiquement la portion de fixation 34 de la première couche métallique 28 coupant ainsi la connexion entre ladite patte de déconnexion 24 et la varistance 21.

Le procédé de fabrication du dispositif de protection contre les surtensions est décrit ci-après. Lors d'une première étape, de la pâte à braser est déposée sur le circuit imprimé 9. Lors d'une deuxième étape, les composants, c'est-à-dire la varistance 21, l'éclateur à gaz 22, la patte de connexion 23 et la patte de déconnexion 24 sont déposés sur le circuit imprimé 9. L'ensemble ainsi formé est passé au four lors d'une troisième étape. Ce passage au four est par exemple réalisé à une température supérieure à 200°C, par exemple de 270°C, et permet de réaliser toutes les brasures en une seule étape à l'exception de la liaison thermofusible entre la patte de déconnexion 24 et la varistance 21. Lors d'une quatrième étape, une soudure à basse température, par exemple comprise entre 130°C et 142°C est utilisée pour former la liaison thermofusible entre la patte de déconnexion 24 et la première couche métallique 28 de la varistance 21. Cette soudure basse température est par exemple réalisée avec un apport d'alliage d'étain - Bismuth sous forme de fil, de patte ou de préforme. L'ensemble ainsi formé est ensuite tropicalisé en utilisant un spray de vernis ou de résine.

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention telle que définie par les revendications.

L'usage du verbe « comporter », « comprendre » ou « inclure » et de ses formes conjuguées n'exclut pas la présence d'autres éléments ou d'autres étapes que ceux énoncés dans une revendication.

Dans les revendications, tout signe de référence entre parenthèses ne saurait être interprété comme une limitation de la revendication.

## Revendications

1. Dispositif de protection contre les surtensions **caractérisé en ce qu'**il comporte :
- un circuit imprimé (9),
- une varistance (21),
- un éclateur à gaz (22), la varistance (21) et l'éclateur à gaz (22) étant connectés en série entre une première borne de connexion électrique (3) et une deuxième borne de connexion électrique (4) du circuit imprimé,
dans lequel :
- la varistance (21) est reliée à la première borne de connexion électrique (3) par une première piste conductrice (14) du circuit imprimé (9),
- l'éclateur à gaz (22) est relié à la varistance (21) par une deuxième piste conductrice (16) du circuit imprimé (9),
- l'éclateur à gaz (22) est relié à la deuxième borne de connexion électrique (4) par une troisième piste de connexion (19) du circuit imprimé (9),
et dans lequel la deuxième piste conductrice (16) et la troisième piste conductrice (19) comportent chacune une portion courbe (36, 37), lesdites portions courbes étant connectées à l'éclateur à gaz et situées de part et d'autre de l'éclateur à gaz (22), lesdites portions courbes présentant chacune une concavité tournée selon une même orientation par rapport à l'éclateur à gaz (22), lesdites portions courbes (36, 37) comportant chacune une zone thermofusible (40, 41) apte à séparer la piste (36, 37) correspondante en deux parties distinctes en réponse à une surintensité, la distance séparant lesdites deux parties distinctes de chaque piste (36, 37) étant configurée pour permettre la génération d'un arc électrique entre lesdites deux parties distinctes en réponse à d'une part une surtension apte à activer l'éclateur à gaz (22) et, d'autre part, un courant et une tension maintenant ledit éclateur à gaz en état de conduction.

2. Dispositif de protection contre les surtensions selon la revendication 1, dans lequel la première piste conductrice (14), la deuxième piste conductrice (16) et la troisième piste conductrice (19) forment conjointement une boucle (38) de champ magnétique ouverte entre la première borne de connexion électrique (3) et la deuxième borne de connexion électrique (4) en présence de courant entre lesdites première borne de connexion électrique (3) et deuxième borne de connexion électrique (4).

3. Dispositif de protection contre les surtensions selon la revendication 1 ou 2, dans lequel un rayon (42) d'un cercle tangent à la zone thermofusible (40) de la deuxième piste conductrice (16) forme un angle compris entre 80 et 100 degrés avec un rayon (43) d'un cercle tangent à la zone thermofusible (41) de la troisième piste conductrice (19).

4. Dispositif de protection contre les surtensions selon l'une des revendications 1 à 3, dans lequel la varistance (21) est reliée à un troisième borne de connexion électrique (2) par une patte de déconnexion (24), ladite patte de déconnexion (24) étant reliée à la varistance (21) par une liaison thermofusible apte à couper la liaison entre la troisième borne de connexion électrique (2) et la varistance (21) en réponse à une élévation de la température de la varistance au-delà d'une valeur seuil, ladite première borne de connexion électrique (2) étant destinée à être connectée à la phase d'un circuit d'alimentation électrique.

5. Dispositif de protection selon l'une des revendications 1 à 4, dans lequel la première borne de connexion électrique (3) est destinée à être connectée au neutre d'un circuit d'alimentation électrique et la deuxième borne de connexion électrique (4) est destiné à être relié à la terre, l'éclateur à gaz (22) étant relié à une quatrième borne (6) électrique par une quatrième piste conductrice (18), ladite quatrième piste conductrice (18) étant connectée à la deuxième piste conductrice (16), ladite quatrième borne de connexion électrique (6) étant destinée à être connectée au neutre d'un circuit électrique alimenté par le circuit d'alimentation électrique.

6. Dispositif de protection selon la revendication 5, dans lequel la varistance (21) est reliée à une cinquième borne de connexion électrique (5) par une sixième piste conductrice (12), ladite cinquième borne de connexion électrique (5) étant destinée à être connectée à la phase du circuit électrique alimenté par le circuit d'alimentation électrique.

7. Procédé de fabrication d'un dispositif de protection contre les surtensions selon l'une quelconques des revendications 1 à 6, comportant :
- fournir un circuit imprimé (9) comportant une pluralité de bornes (2, 3, 4, 5, 6) de connexion électrique et une pluralité de pistes (10, 12, 14, 16, 18, 19) de connexion conductrices,
- fournir une varistance(21),
- fournir un éclateur à gaz (22),
- déposer la varistance (21) sur le circuit imprimé (9) de sorte que la varistance (21) soit reliée à une première borne de connexion électrique (3) par une première piste conductrice (14),
- déposer l'éclateur à gaz (22) sur le circuit imprimé (9) de sorte que la varistance (21) et l'éclateur à gaz (22) soient connectés en série entre la première borne de connexion électrique (3) et une deuxième borne de connexion électrique (4) du circuit imprimé (9) via une deuxième piste conductrice (16) reliant la varistance (21) et l'éclateur à gaz (22) et une troisième piste conductrice (19) reliant l'éclateur à gaz (22) à ladite deuxième borne de connexion électrique (4), la deuxième piste conductrice (16) et la troisième piste conductrice (19) comportent chacune une portion courbe (36, 37), lesdites portions courbes (36, 37) étant connectées à l'éclateur à gaz (22) et situées de part et d'autre de l'éclateur à gaz (22), lesdites portions courbes (36, 37) présentant chacune une concavité tournée selon une même orientation par rapport à l'éclateur à gaz (22), lesdites portions courbes (36, 37) comportant chacune une zone thermofusible (40, 41) apte à séparer la piste (36, 37) correspondante en deux parties distinctes en réponse à une surintensité, la distance séparant lesdites deux parties distinctes desdites pistes (36, 37) étant configurée pour permettre la génération d'un arc électrique entre lesdites deux parties distinctes en réponse à d'une part une surtension apte à activer l'éclateur à gaz (22) et, d'autre part, un courant et une tension maintenant ledit éclateur à gaz (22) en état de conduction.

8. Procédé selon la revendication 7, dans lequel la varistance (21) présente un corps de varistance en oxyde métallique qui présente une face (25) et une couche métallique (28) conductrice déposée sur ladite face (25),
comportant en outre :
- déposer une patte de déconnexion (24) sur une quatrième piste conductrice (10) du circuit imprimé (9), ladite quatrième piste conductrice (10) reliant ladite patte de déconnexion (24) et une troisième borne de connexion électrique (2), l'étape de déposer la varistance (21) sur le circuit imprimé (9) est réalisée de sorte que l'extrémité de la patte de déconnexion (24) opposée à la première piste conductrice (10) soit en vis-à-vis et à distance de la couche métallique (28) de la varistance (21),
- déformer élastiquement la patte de déconnexion (24) de manière à amener la deuxième extrémité de ladite patte de déconnexion (24) en contact avec la couche métallique (28), et
- réaliser une soudure thermofusible entre ladite extrémité de la patte de déconnexion (24) et la couche métallique (28).

## Patentansprüche

1. Schutzvorrichtung gegen Überspannungen, umfassend:
- eine Leiterplatte (9),
- einen Varistor (21),
- eine gasgefüllte Funkenstrecke (22), wobei der Varistor (21) und die gasgefüllte Funkenstrecke (22) in Reihe geschaltet sind zwischen einer ersten elektrischen Anschlussklemme (3) und einer zweiten elektrischen Anschlussklemme (4) der Leiterplatte,
wobei:
- der Varistor (21) mit der ersten Anschlussklemme (3) mittels einer ersten Leiterbahn (14) der Leiterplatte (9) verbunden ist,
- die gasgefüllte Funkenstrecke (22) mit dem Varistor (21) mittels einer zweiten Leiterbahn (16) der Leiterplatte (9) verbunden ist,
- die gasgefüllte Funkenstrecke (22) mit der zweiten elektrischen Anschlussklemme (4) mittels einer dritten Leiterbahn (19) der Leiterplatte (9) verbunden ist,
und wobei die zweite Leiterbahn (16) und die dritte Leiterbahn (19) jeweils einen gekrümmten Abschnitt (36, 37) umfassen, wobei die gekrümmten Abschnitte mit der gasgefüllten Funkenstrecke verbunden sind und an beiden Seiten der gasgefüllten Funkenstrecke (22) angeordnet sind, wobei die gekrümmten Abschnitte eine Konkavität aufweisen, welche im Verhältnis zur gasgefüllten Funkenstrecke (22) in gleicher Ausrichtung ausgerichtet ist, wobei die gekrümmten Abschnitte (36, 37) einen wärmeschmelzbaren Bereich (40, 41) umfassen, welcher dazu geeignet ist, die jeweilige Bahn (36, 37) in zwei abgetrennte Bereiche als Reaktion auf einen Überstrom zu trennen, wobei der Abstand, welcher die zwei abgetrennten Bereiche von jeder Bahn (36, 37) trennt, so konfiguriert ist, dass die Bildung eines Lichtbogens zwischen den beiden abgetrennten Bereichen als Reaktion auf zum einen eine Überspannung, welche die Aktivierung der gasgefüllten Funkenstrecke (22) ermöglicht und auf zum anderen einen Strom und einer Spannung, welche die gasgefüllte Funkenstrecke in einem leitenden Zustand halten, möglich ist.

2. Schutzvorrichtung gegen Überspannungen gemäß Anspruch 1, wobei die erste Leiterbahn (14), die zweite Leiterbahn (16) und die dritte Leiterbahn (19) gemeinsam eine offene Magnetfeldschleife (38) zwischen der ersten elektrischen Anschlussklemme (3) und der zweiten elektrischen Anschlussklemme (4) bei einem Stromfluss zwischen der ersten elektrischen Anschlussklemme (3) und der zweiten elektrischen Anschlussklemme (4) bilden.

3. Schutzvorrichtung gegen Überspannungen gemäß Anspruch 1 oder 2, wobei der Radius (42) eines zum wärmeschmelzbaren Bereich (40) der zweiten Leiterbahn (16) tangentialen Kreises mit dem Radius (43) eines zum wärmeschmelzbaren Bereich (41) der dritten Leiterbahnen (19) tangentialen Kreises einen Winkel zwischen 80 und 100° bilden.

4. Schutzvorrichtung gegen Überspannungen gemäß einem der Ansprüche 1 bis 3, wobei der Varistor (21) mit einer dritten elektrischen Anschlussklemme (2) mittels einer Trennungslasche (24) verbunden ist, wobei die Trennungslasche (24) mit dem Varistor (21) mittels einer wärmeschmelzbaren Verbindung, welche dazu geeignet ist, die Verbindung zwischen der dritten elektrischen Anschlussklemme (2) und dem Varistor (21) als Reaktion auf eine Erhöhung der Temperatur des Varistors über einen Grenzwert hinaus zu trennen, verbunden ist, wobei die erste elektrische Anschlussklemme (2) dazu bestimmt ist, mit der Phase eines Stromversorgungskreislaufes verbunden zu sein.

5. Schutzvorrichtung gemäß einem der Ansprüche 1 bis 4, wobei die erste elektrische Anschlussklemme (3) dazu bestimmt ist, mit dem Neutralleiter eines Stromversorgungskreislaufes verbunden zu sein, und die zweite elektrische Anschlussklemme (4) dazu bestimmt ist, mit der Erde verbunden zu sein, wobei die gasgefüllte Funkenstrecken (22) mit einer vierten elektrischen Anschlussklemme (6) mittels einer vierten Leiterbahn (18) verbunden ist, wobei die vierte Leiterbahn (18) mit der zweiten Leiterbahn (16) verbunden ist, wobei die vierte elektrische Anschlussklemme (6) dazu bestimmt ist, mit dem Neutralleiter eines Stromkreislaufes, welcher durch den Stromversorgungskreislauf einspeisbar ist, verbunden zu sein.

6. Schutzvorrichtung gemäß Anspruch 5, wobei der Varistor (21) mit einer fünften elektrischen Anschlussklemme (5) mittels einer sechsten Leiterbahn (12) verbunden ist, wobei die fünfte elektrische Anschlussklemme (5) dazu bestimmt ist, mit der Phase des Stromkreislaufes, welcher durch den Stromversorgungskreislauf einspeisbar ist, verbunden zu sein.

7. Verfahren zur Herstellung einer Schutzvorrichtung gegen Überspannungen, umfassend:
- Bereitstellen einer Leiterplatte (9), welche eine Vielzahl von elektrischen Anschlussklemmen (2, 3, 4, 5, 6) und eine Vielzahl von Leiterbahnen (10, 12, 14, 16, 18, 19) umfasst,
- Bereitstellen eines Varistors (21)
- Bereitstellen einer gasgefüllten Funkenstrecke (22),
- Anordnen des Varistors (21) auf der Leiterplatte (9) derart, dass der Varistor (21) mit einer ersten elektrischen Anschlussklemme (3) mittels einer ersten Leiterbahn (14) verbunden ist,
- Anordnen der gasgefüllten Funkenstrecke (22) auf der Leiterplatte (9) derart, dass der Varistor (21) und die gasgefüllte Funkenstrecke (22) in Reihe geschaltet sind zwischen der ersten elektrischen Anschlussklemme (3) und einer zweiten elektrischen Anschlussklemme (4) der Leiterplatte (9) mittels einer zweiten Leiterbahn (16), welche den Varistor (21) und die gasgefüllte Funkenstrecke (22) verbindet, und einer dritten Leiterbahn (19), welche die gasgefüllte Funkenstrecke (22) mit der zweiten elektrischen Anschlussklemme (4) verbindet, wobei die zweite Leiterbahn (16) und die dritte Leiterbahn (19) jeweils einen gekrümmten Abschnitt (36, 37) umfassen, wobei die gekrümmten Abschnitte mit der gasgefüllten Funkenstrecke verbunden sind und an beiden Seiten der gasgefüllten Funkenstrecke (22) angeordnet sind, wobei die gekrümmten Abschnitte eine Konkavität aufweisen, welche im Verhältnis zur gasgefüllten Funkenstrecke (22) in gleicher Ausrichtung ausgerichtet ist, wobei die gekrümmten Abschnitte (36, 37) einen wärmeschmelzbaren Bereich (40, 41) umfassen, welcher dazu geeignet ist, die jeweilige Bahn (36, 37) in zwei abgetrennte Bereiche als Reaktion auf einen Überstrom zu trennen, wobei der Abstand, welcher die zwei abgetrennten Bereiche von jeder Bahn (36, 37) trennt, so konfiguriert ist, dass die Bildung eines Lichtbogens zwischen den beiden abgetrennten Bereichen als Reaktion auf zum einen eine Überspannung, welche die Aktivierung der gasgefüllten Funkenstrecke (22) ermöglicht und auf zum anderen einen Strom und einer Spannung, welche die gasgefüllte Funkenstrecke (22) in einem leitenden Zustand halten, möglich ist.

8. Verfahren gemäß Anspruch 7, wobei der Varistor (21) einen Varistorkörper aus Metalloxid aufweist, welcher eine Seite (25) und eine leitende metallische Schicht (28), welche auf der Seite (25) angeordnet ist, aufweist, weiterhin umfassend:
- Anordnen einer Trennungslasche (24) auf einer vierten Leiterbahn (10) der Leiterplatte (9), wobei die vierte Leiterbahn (10) die Trennungslasche (24) mit einer dritten elektrischen Anschlussklemme (2) verbindet, wobei der Schritt des Anordnen des Varistors (21) auf der Leiterplatte (9) so ausgeführt wird, dass der Endabschnitt der Trennungslasche (24), welcher gegenüberliegend der ersten Leiterbahn (10) angeordnet ist, gegenüberliegend und beabstandet von der metallischen Schicht (28) des Varistors ist,
- elastisches Verformen der Trennungslasche (24) derart, dass der zweite Endabschnitt der Trennungslasche (24) in Kontakt mit der Metallschicht (28) tritt, und
- Erzeugen einer wärmeschmelzbaren Schweißnaht zwischen dem Endabschnitt der Trennungslasche (24) und der Metallschicht (28).

## Claims

1. Overvoltage protection device **characterized in that** it comprises:
- a printed circuit board (9),
- a varistor (21),
- a gas discharge tube (22), the varistor (21) and the gas discharge tube (22) being connected in series between a first electrical connection terminal (3) and a second electrical connection terminal (4) of the printed circuit board, wherein:
- the varistor (21) is connected to the first electrical connection terminal (3) by a first conductive track (14) of the printed circuit board (9),
- the gas discharge tube (22) is connected to the varistor (21) by a second conductive track (16) of the printed circuit board (9),
- the gas discharge tube (22) is connected to the second electrical connection terminal (4) by a third conductive track (19) of the printed circuit board (9),
and wherein the second conductive track (16) and the third conductive track (19) each have a curved portion (36, 37), said curved portions being connected to the gas discharge tube and situated on either side of the gas discharge tube (22), said curved portions each having a concavity facing in one and the same orientation with respect to the gas discharge tube (22), said curved portions (36, 37) each having a thermofusible area (40, 41) able to separate the corresponding track (36, 37) into two separate parts in response to an overcurrent, the distance between said two separate parts of each track (36, 37) being configured so as to allow the generation of an electrical arc between said two separate parts in response firstly to an overvoltage able to activate the gas discharge tube (22) and secondly a current and a voltage that keep said gas discharge tube in the conductive state.

2. Overvoltage protection device according to Claim 1, wherein the first conductive track (14), the second conductive track (16) and the third conductive track (19) together form an open magnetic field loop (38) between the first electrical connection terminal (3) and the second electrical connection terminal (4) in the presence of a current between said first electrical connection terminal (3) and second electrical connection terminal (4).

3. Overvoltage protection device according to Claim 1 or 2, wherein a radius (42) of a circle tangent to the thermofusible area (40) of the second conductive track (16) forms an angle of between 80 and 100 degrees with a radius (43) of a circle tangent to the thermofusible area (41) of the third conductive track (19).

4. Overvoltage protection device according to one of Claims 1 to 3, wherein the varistor (21) is connected to a third electrical connection terminal (2) by a disconnection tab (24), said disconnection tab (24) being connected to the varistor (21) by a thermofusible link able to disconnect the link between the third electrical connection terminal (2) and the varistor (21) in response to an increase in the temperature of the varistor beyond a threshold value, said first electrical connection terminal (2) being intended to be connected to the phase of an electric power supply circuit.

5. Protection device according to one of Claims 1 to 4, wherein the first electrical connection terminal (3) is intended to be connected to the neutral of an electric power supply circuit and the second electrical connection terminal (4) is intended to be connected to ground, the gas discharge tube (22) being connected to a fourth electrical terminal (6) by a fourth conductive track (18), said fourth conductive track (18) being connected to the second conductive track (16), said fourth electrical connection terminal (6) being intended to be connected to the neutral of an electrical circuit supplied with power by the electric power supply circuit.

6. Protection device according to Claim 5, wherein the varistor (21) is connected to a fifth electrical connection terminal (5) by a sixth conductive track (12), said fifth electrical connection terminal (5) being intended to be connected to the phase of the electrical circuit supplied with power by the electric power supply circuit.

7. Method for manufacturing an overvoltage protection device according to any one of claims 1 to 6, comprising:
- providing a printed circuit board (9) having a plurality of electrical connection terminals (2, 3, 4, 5, 6) and a plurality of conductive connection tracks (10, 12, 14, 16, 18, 19),
- providing a varistor (21),
- providing a gas discharge tube (22),
- depositing the varistor (21) on the printed circuit board (9) such that the varistor (21) is connected to a first electrical connection terminal (3) by a first conductive track (14),
- depositing the gas discharge tube (22) on the printed circuit board (9) such that the varistor (21) and the gas discharge tube (22) are connected in series between the first electrical connection terminal (3) and a second electrical connection terminal (4) of the printed circuit board (9) via a second conductive track (16) connecting the varistor (21) and the gas discharge tube (22) and a third conductive track (19) connecting the gas discharge tube (22) to said second electrical connection terminal (4), the second conductive track (16) and the third conductive track (19) each having a curved portion (36, 37), said curved portions (36, 37) being connected to the gas discharge tube (22) and situated on either side of the gas discharge tube (22), said curved portions (36, 37) each having a concavity facing in one and the same orientation with respect to the gas discharge tube (22), said curved portions (36, 37) each having a thermofusible area (40, 41) able to separate the corresponding track (36, 37) into two separate parts in response to an overcurrent, the distance between said two separate parts of said tracks (36, 37) being configured so as to allow the generation of an electrical arc between said two separate parts in response firstly to an overvoltage able to activate the gas discharge tube (22) and secondly a current and a voltage that keep said gas discharge tube (22) in the conductive state.

8. Method according to Claim 7, wherein the varistor (21) has a varistor body made of metal oxide, having a face (25) and a conductive metal layer (28) deposited on said face (25),
furthermore comprising:
- depositing a disconnection tab (24) on a fourth conductive track (10) of the printed circuit board (9), said fourth conductive track (10) connecting said disconnection tab (24) and a third electrical connection terminal (2), the step of depositing the varistor (21) on the printed circuit board (9) is performed such that the end of the disconnection tab (24) opposite the first conductive track (10) faces and is spaced from the metal layer (28) of the varistor (21),
- elastically deforming the disconnection tab (24) so as to bring the second end of said disconnection tab (24) into contact with the metal layer (28), and
- performing thermofusible soldering between said end of the disconnection tab (24) and the metal layer (28).
